(19)

Europäisches Patentamt

European Patent Office

Office européen des brevets

(11) **EP 2 871 668 B1**

(12) **EUROPEAN PATENT SPECIFICATION**

(45) Date of publication and mention of the grant of the patent:
**25.04.2018 Bulletin 2018/17**

(21) Application number: **14772860.4**

(22) Date of filing: **19.03.2014**

(51) Int Cl.:
*H01L 21/02* (2006.01)       *H01L 27/12* (2006.01)
*H01L 21/20* (2006.01)       *H01L 29/786* (2006.01)

(86) International application number:
**PCT/JP2014/058704**

(87) International publication number:
**WO 2014/157430 (02.10.2014 Gazette 2014/40)**

(54) **HANDLE SUBSTRATE FOR COMPOUND SUBSTRATE FOR USE WITH SEMICONDUCTOR**

GRIFFSUBSTRAT FÜR EIN VERBUNDSUBSTRAT ZUR VERWENDUNG MIT EINEM HALBLEITER

SUBSTRAT DE MANIPULATION POUR SUBSTRAT À COMPOSÉ POUR UTILISATION AVEC UN SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.03.2013   JP 2013066455**

(43) Date of publication of application:
**13.05.2015   Bulletin 2015/20**

(73) Proprietor: **NGK Insulators, Ltd.**
**Nagoya-shi, Aichi 467-8530 (JP)**

(72) Inventors:
• **IDE, Akiyoshi**
**Nagoya-shi**
**Aichi 467-8530 (JP)**

• **IWASAKI, Yasunori**
**Nagoya-shi**
**Aichi 467-8530 (JP)**
• **MIYAZAWA, Sugio**
**Nagoya-shi**
**Aichi 467-8530 (JP)**

(74) Representative: **TBK**
**Bavariaring 4-6**
**80336 München (DE)**

(56) References cited:
**EP-A1- 2 100 989       JP-A- 2002 193 672**
**JP-A- 2002 201 076     JP-A- 2012 109 399**
**JP-A- 2013 033 798     US-A1- 2012 228 612**

**Description**

Technical Field

The present invention relates to a handle substrate of a composite substrate for a semiconductor.

BACKGROUND ARTS

According to prior arts, it has been known to obtain SOI including a handle substrate composed of a transparent and insulating substrate and called Silicon on Quartz (SOQ), Silicon on Glass (SOG) and Silicon on Sapphire (SOS), and to obtain an adhered wafer by bonding a transparent wide-gap semiconductor including GaN, ZnO, diamond, AlN or the like to a donor substrate such as silicon. SOQ, SOG, SOS and the like are expected for applications such as a projector and high frequency device due to the insulating property and transparency of the handle substrate. Further, the adhered wafer, which is a composite of a thin film of the wide-gap semiconductor and the handle substrate, is expected in applications such as a high performance laser and power device.

Such composite substrate for a semiconductor integrated circuit is composed of a handle substrate and donor substrate, and the handle and donor substrates are generally made of single crystal materials. According to prior arts, it was generally performed a method of forming a silicon layer on a base substrate by epitaxial growth. It has recently developed a method of directly bonding them to contribute to the improvement of performance of a semiconductor device (Patent documents 1, 2 and 3). That is, such handle and donor substrates are bonded through a bonding layer or an adhesive layer or directly bonded with each other. Further, as the development of the bonding technique, it has been proposed various kinds of handle substrates made of materials, other than sapphire, such as quartz, glass and alumina (Patent documents 4, 5, 6 and 7).

(Prior technical documents)

(Patent document 1) Japanese Patent Publication No. H08-512432A
(Patent document 2) Japanese Patent Publication No. 2003-224042A
(Patent document 3) Japanese Patent Publication No. 2010-278341A
(Patent document 4) WO 2010/128666 A1
(Patent document 5) Japanese Patent Publication No. H05-160240A
(Patent document 6) Japanese Patent Publication No. H05-160240A
(Patent document 7) Japanese Patent Publication No. 2008-288556A

Prior art which is related to this field of technology can be found e.g. in document EP 2 100 989 A1 disclosing a method for preparing substrate having monocrystalline film, and in document US 2012/0228612 A1 disclosing a composite base including sintered base and base surface flattening layer, and composite substrate including that composite base and semiconductor crystalline layer.

SUMMARY OF THE INVENTION

As to the handle substrate used for the bonding with the donor substrate, it is desirable to subject it to high-precision polishing by CMP or the like to make its Ra value not higher than 5nm, for maximizing the bonding force due to intermolecular force. However, the thus produced composite substrate is sometimes subjected to atmosphere at a temperature near 1000°C during various kinds of semiconductor processes. Therefore, in the case that a material of a functional layer is different from those of the supporting substrate and bonding layer, it may occur the problem of peeling of the substrate due to difference of thermal expansion of the respective materials. It is thus desired to make the Ra value of the handle substrate surface low for maximizing the bonding force due to intermolecular force and, at the same time, to endure thermal stress due to the high temperature processes after the bonding.

An object of the present invention is to provide a handle substrate of a composite substrate for a semiconductor, in which the handle substrate can be bonded with a donor substrate and its resistance against thermal stress during high temperature process after the bonding can be improved.

The present invention provides a composite substrate according to the claims.

In the case that the handle substrate is composed of a sapphire substrate, it is possible to make a surface of the handle substrate extremely smooth. However, after the composite substrate after the bonding is subjected to high temperature process, cracks or peeling tends to occur due to a difference of thermal expansion between the handle and donor substrates.

Thus, the inventors have formed the handle substrate from a polycrystalline material. Here, such polycrystalline material has microstructure in which many fine grains are bonded together. After the polycrystalline material is shaped as such, the inventors reached the idea of subjecting the surface to high-precision polishing appropriately to sufficiently lower Ra and, at the same time, of forming height differences on the surface depending on the crystal orientations of the crystal grains as a measure for solving the peeling-off of the substrate due to the difference of thermal expansion.

As described above, it was possible to bond it with the donor substrate by making the surfaces of the crystal grains smooth microscopically. Simultaneously, the bonding layer or adhesive are filled in the height difference parts, so that the cracks or peeling due to the difference of thermal expansion of the respective materials can be prevented by anchor effect.

Brief Description of the Drawings

Fig. 1(a) is a view schematically showing surface region of a handle substrate 11 according to the present invention, and Fig. 1(b) is a view schematically showing surface region of a handle substrate 11A according to the present invention.

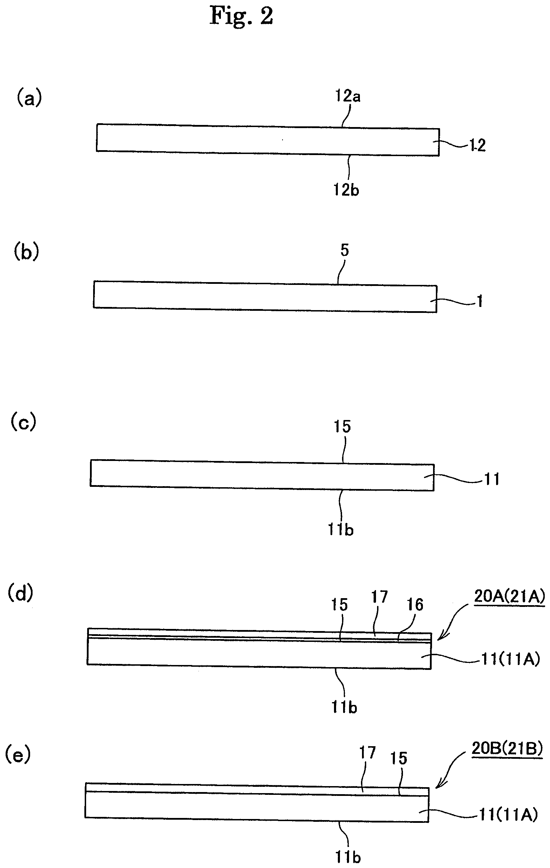

Fig. 2(a) shows a blank substrate 12 made of a polycrystalline material, Fig. 2(b) shows a substrate material 1 obtained by subjecting the blank substrate 12 to high-precision polishing, Fig. 2(c) shows a handle substrate 11 obtained by further polishing the substrate material 1, Fig. 2(d) shows a composite substrate 20A (21A) obtained by bonding the handle substrate 11(11A) with a donor substrate 17 provided thereon through a bonding layer 16, and Fig. 2(e) shows a composite substrate 20B (21B) obtained by directly bonding the handle substrate 11 (11A) with the donor substrate 17 provided thereon.

Fig. 3(a) is a view schematically showing microstructure of the composite substrate 20A obtained by bonding the handle substrate 11 with the donor substrate 17 provided thereon through the bonding layer 16, and Fig. 3(b) is a view schematically showing microstructure of the composite substrate 20B obtained by directly bonding the handle substrate 11 with the donor substrate 17 provided thereon.

Fig. 4(a) is a view schematic showing microstructure of a composite substrate 21A obtained by bonding the donor substrate 17 onto the handle substrate 11A through a bonding layer 16, and Fig. 4(b) is a view schematically showing microstructure of a composite substrate 21B obtained by directly bonding the donor substrate 17 onto the handle substrate 11A.

Fig. 5 is a photograph of a handle substrate according to the present invention taken by AFM (Atomic Force Microscope).

Fig. 6 is a diagram schematically illustrating the photograph of Fig. 5.

Embodiments for carrying out the Invention

The present invention will be described further, referring to the drawings appropriately.

First, as shown in Fig. 2(a), it is prepared a blank substrate 12 made of a polycrystalline material. A surface 12a and bottom face 12b of the blank substrate 12 may be a ground surface or a sintered surface (as-fired surface).

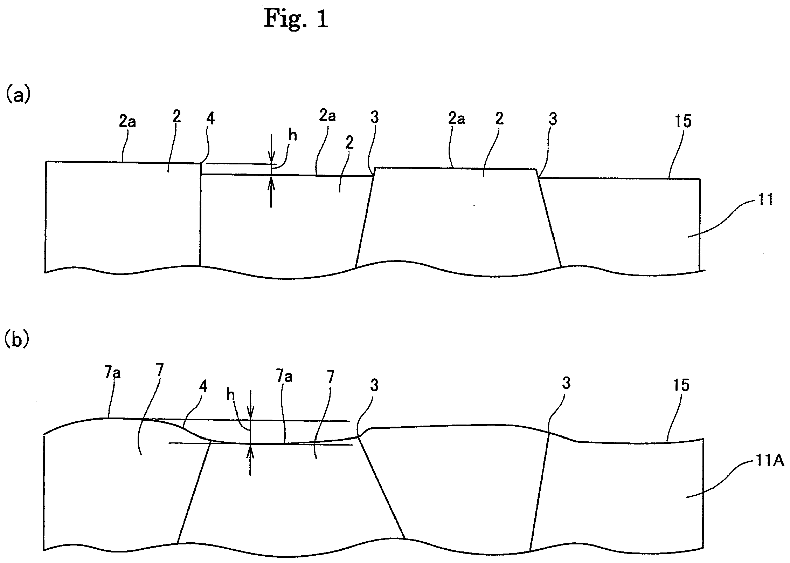

The polycrystalline material has microstructure in which many fine grains are bonded together. As shown in Fig. 1, the polycrystalline material is constituted by crystal grains 2, 7 randomly distributed. The surface 12a of the blank substrate 12 is subjected to high-precision polishing to obtain a substrate material 1 having a polished face 5 as shown in Fig.2(b). In the vicinity of the polished face 5, crystal grains 1 and 7 are polished along a plane, and the polished crystal grains 2 and 7, each having a flat surface, are exposed to the surface. The respective exposed faces 2a and 7a of the polished crystal grains 2 and 7 become smooth.

The thus formed surface 5 after the high precision polishing is then subjected to wet etching or CMP (chemical mechanical polishing) as additional finishing to form convexes and concaves derived from the crystal grains on the substrate surface, as shown in Figs. 2(c), 1(a) and 1(b).

That is, the crystal orientations of the respective crystal grains 2 and 7 forming the polycrystalline material are different from each other. Then, in the case that the high-precision polishing is performed and chemical treatment such as etching is performed to the polished face, process rates of the respective crystal grains are different from each other. For example, in Fig. 1, the process rates of the respective crystal grains 2 and 7 are different. After the finishing, height differences h are thereby formed between the respective surfaces 2a, 7a of the adjoining crystal grains 2, 7. Random and fine convexes and concaves could be successfully formed on the substrate surface, without performing a process such as patterning or the like on the surface.

According to the thus obtained handle substrates 11 and 11A, the microscopic central line average roughness Ra of the surface 15 is 5nm or smaller, and it was formed the height differences h along interfaces 3 between the adjoining crystal grains 2 and 7 and the height differences h are derived from the differences of the process rates due to the differences of the crystal orientations of the respective crystal grains 2 and 7.

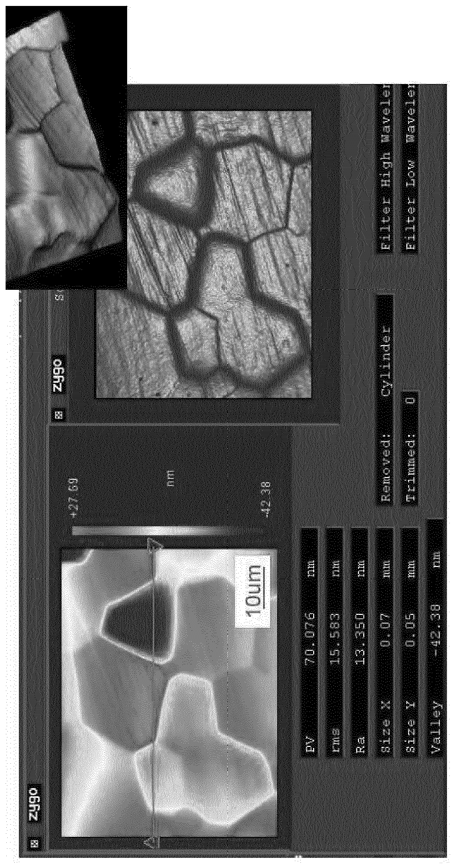

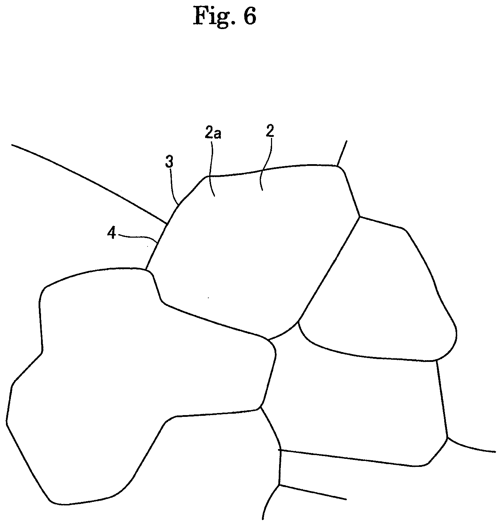

The surface shown in the schematic views of Figs. 1(a) and 1(b) is shown in a photograph of Fig. 5 as an example. Further, the photographs of Fig. 5 are converted to schematic diagrams, which are shown in Fig. 6. According to the photograph shown in the left side of Fig. 5, darker parts correspond to the exposed faces 2a of the grains 2 and brighter and longer lines correspond to the intergranular boundaries 3. According to the photograph on the right side of Fig. 5, contrast processing was performed and the intergranular boundaries 3 are shown as elongate and black lines. Then, the photograph shown on the upper right side of Fig. 5 is a perspective view, in which the height differences 3 are clearly shown along the intergranular boundaries between the adjoining grains.

Here, according to the example of Fig. 1(a), edges 4 forming the height differences of the respective crystal grains are sharp. Further, according to the example of Fig. 1(b), edges forming the height differences of the respective crystal grains 7 are smooth.

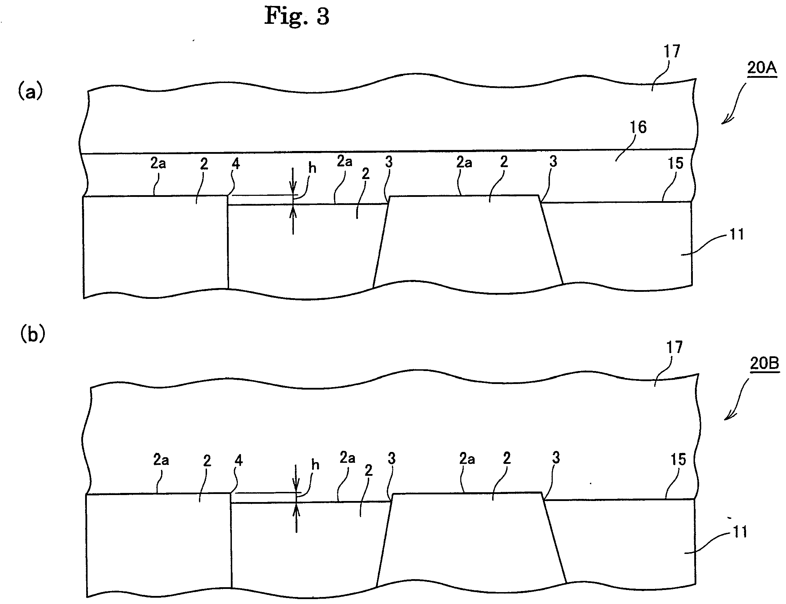

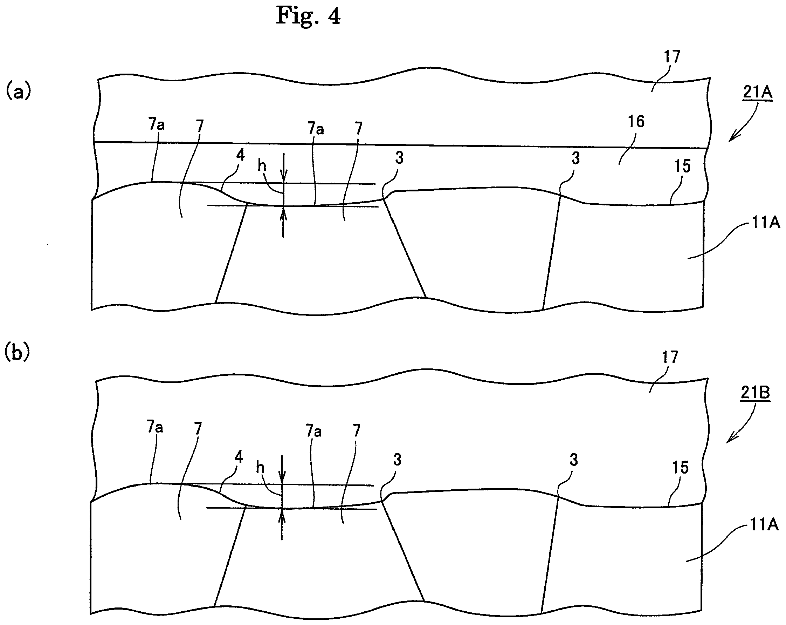

After the handle substrate 11 or 11A is obtained, the donor substrate 17 can be bonded to the surface 15 of the handle substrate 11 or 11A. According to the example of Figs. 3(a) and 4(a), the donor substrate 17 is bonded with the surface 15 of the handle substrate 11 or 11A through the bonding layer 16. In this case, as the surface 15 of the handle substrate 11 or 11A is flat in microscopic view, it is possible to improve the bonding strength with the donor substrate. Further, as a material forming the bonding layer 16 is included into the inside of the height difference to exhibit a kind of anchor effect, it is proved that the peeling and cracks, due to the difference of thermal expansion of the donor substrate and the handle substrate, can be prevented.

Further, according to the example shown in Figs. 3(b) and 4(b), the donor substrate 17 is directly bonded to the surface 15 of the handle substrate 11 or 11A. In this case, as the surface of the handle substrate 11 or 11A is flat in microscopic view, it is possible to improve the bonding strength with the donor substrate. Further, as a material forming the donor substrate is included into the inside of the height difference to exhibit a kind of anchor effect, it is proved that the peeling or cracks, due to the difference of thermal expansion of the donor substrate and the handle substrate, can be prevented.

Elements of the present invention will be described further below.

(Composite substrate for semiconductor)

The composite substrate of the present invention can be utilized for a semiconductor, especially semiconductor circuit board, for a projector, high frequency device, high performance laser, power device, logic IC or the like.

The composite substrate includes the inventive handle substrate and a donor substrate.

Materials of the donor substrates are not particularly limited, and may preferably be selected from the group consisting of silicon, aluminum nitride, gallium nitride, zinc oxide and diamond. The thickness of the donor substrate is not particularly limited, and may be near that of conventional SEMI/JEIDA standard on the viewpoint of handling.

The donor substrate may include the above described material whose surface may include an oxide film. It is because the effect of preventing channeling of implanted ions is obtained by performing ion implantation through the oxide film. The oxide film preferably has a thickness of 50 to 500nm. Such donor substrate including the oxide film is also categorized as the donor substrate, and it is called donor substrate unless specifically indicated.

(Handle substrate)

The thickness of the handle substrate is not particularly limited, and may be near that of conventional SEMI/JEIDA standard on the viewpoint of handling.

The material of the handle substrate is a polycrystalline material. The polycrystalline material is not particularly limited, and may preferably be selected from the group consisting of silicon oxide, aluminum oxide, aluminum nitride, silicon carbide, silicon nitride, sialon and gallium nitride.

The crystal grain size of the polycrystalline material may preferably be 1 $\mu$ m or larger, so that it is possible to lower the microscopic central line average surface roughness Ra and to improve the bonding strength of the donor substrate due to intermolecular force. On the viewpoint, the size of the crystal grains of the polycrystalline material may preferably be 10 $\mu$ m or larger.

Further, the size of the crystal grain of the polycrystalline material may preferably be 100 $\mu$ m or smaller. It is thereby possible to further improve the effects of the height differences.

Further, the relative density of the polycrystalline material forming the handle substrate may preferably be 98 percent or larger and more preferably be 99 percent or larger, on the viewpoint of endurance against the subsequent process of a semiconductor and prevention of contamination of it.

(Translucent alumina ceramics)

As the polycrystalline material, translucent alumina ceramics may most preferably be used. As the reason, an extremely dense sintered body can be obtained, so that fracture and cracks of the handle substrate are hardly generated even when stress is concentrated on the recess-formed portions.

Methods of molding the translucent alumina substrate is not particularly limited, and may be an optional process such as doctor blade, extrusion, gel casting or the like. Most preferably, the substrate is produced utilizing gel cast molding. According to a preferred embodiment, slurry containing ceramic powder, dispersing agent and gelling agent is cast into a mold, the slurry is then gelled to obtain a molded body, and the molded body is sintered.

Most preferably, it is used raw material composed of high-purity alumina powder having a purity of 99.9 Percent or higher (preferably 99.95 percent or higher) and 150 to 1000 ppm of an aid added to the powder. Such high-purity alumina powder includes high-purity alumina powder produced by Taimei Chemical Industries Corporation.

As the aid described above, although magnesium oxide is preferred, $ZrO_2$, $Y_2O_3$, $La_2O_3$ and $SC_2O_3$ are exemplified.

According to a preferred embodiment, an amount of an impurity, other than alumina, contained in the translucent alumina substrate is 0.2 mass percent or smaller, so that it is possible to prevent the contamination of a semiconductor. The present invention is thus particularly useful.

The average particle size (primary particle size) of the raw material is not particularly limited, and may preferably be 0.5 $\mu$ m or smaller and more preferably be 0.4 $\mu$ m or smaller, on the viewpoint of densification by the sintering at a low temperature. More preferably, the average particle size of the powdery raw material is 0.3 $\mu$ m or smaller. The lower limit of the average particle diameter is not particularly limited. The average particle size of the powdery raw material can be decided by direct observation of the powdery raw material using SEM (Scanning type electron microscope).

Besides, the average particle size means an average value of n=500 values of (length of the longest axis+ length of the shortest axis)/2 of primary particles, excluding secondary aggregated particles, in optical two visual fields at a magnitude of $\times$ 30000 of SEM photograph.

The gel cast molding includes the following methods.

(1) Inorganic powder, prepolymer as a gelling agent such as polyvinyl alcohol, epoxy resin, phenol resin or the like and a dispersing agent are dispersed in dispersing medium to produce slurry, which is cast into a mold and then cross-linked three-dimensionally using a cross-linking agent to perform the gelation, so that the slurry is solidified.
(2) An organic dispersing medium having a reactive functional group and gelling agent are chemically bonded to each other to solidify the slurry.

(Microstructure of surface of handle substrate)

According to the present invention, the central line average surface roughness Ra of the surface of the handle substrate in microscopic view is 5nm or smaller. If it is too large, the bonding strength to the donor substrate is reduced due to intermolecular force. It may preferably be 3nm or smaller and more preferably be 1nm or smaller, on the viewpoint of the present invention. Besides, it is a value obtained by taking an image of the exposed face 2a or 7a of each crystal grain 2 or 7 (refer to Figs. 1(a) and 1(b)) exposed to the surface by means of an atomic force electron microscope and by calculating the value as described below.

According to the present invention, the height differences are provided between the exposed faces of the crystal grains exposed to the surface of the handle substrate. The intergranular boundaries 3 are exposed between the exposed faces 2a and 7a of the crystal grains 2 and 7, forming the polycrystalline material, exposed to the surface, and the height differences are formed along the intergranular boundaries 3. Therefore, the height differences do not directly affect the microscopic center line average surface roughness Ra.

The size h of the thus formed height difference in PV value is 3 nm or larger, so that it is possible to facilitate the anchor effect with respect to the donor substrate and bonding layer. On the viewpoint, the size h of the height difference in PV value may preferably be 5nm or larger and more preferably be 8nm or larger. Further, the size h of the height difference in PV value is 100nm or smaller, so that it is possible to prevent the influences of the intermolecular force on the bonding with the donor substrate. On the viewpoint, the size h of the height difference in PV value may preferably be 50nm or smaller and more preferably be 30nm or smaller.

The edge 4 of the crystal grain at the height difference in the grain boundary may be sharp as shown in Fig. 1(a). In this case, more considerable anchor effect can be expected. On the other hand, in the case that the edge 4 of the crystal grain at the height difference in the intergranular boundary is smooth as shown in Fig. 1(b), starting point of concentration of stress is hardly present, so that cracks and fracture in the inside of the bonding layer can be easily prevented.

(Crystal orientation of handle substrate)

As a measure for forming the height differences according to the present invention, it is suitable to make the crystal grains of the polycrystalline material forming the handle substrate oriented. As the process rate of the crystal grains having the same orientation is same, height differences having a constant height are formed at the same time after the polishing. In the case that the crystals are not orientated at all, the process rates of the respective crystal grains would become different from each other, so that the heights of the height differences would not be same and would be deviated. Therefore, in the case that a plurality of the crystals forming the handle substrate have the same orientation, it is possible to increase surface areas of the crystal effective for forming the bonding. At the same time, by providing the crystals having different orientations, it is possible to facilitating the anchor effect more effectively.

An oriented ceramics means one in which crystal grains forming the ceramics are aligned in a predetermined direction. The crystal orientation of a polycrystalline material forming the handle substrate may preferably be 30 percent or more and more preferably be 50 percent or more, on the viewpoint as described above. Further, for maintaining the ratio of the height differences, the crystal orientation of the polycrystalline material forming the handle substrate may preferably be 95 percent or lower and more preferably be 90 percent or lower.

The crystal orientation of the polycrystalline material is measured by Lotgering method.

Specifically, XRD diffraction pattern on the bonding face is measured to calculate it according to the following formula.

$$\text{Orientation} = \frac{\dfrac{\sum' I(HKL)}{\sum I(hkl)} - \dfrac{\sum' I_0(HKL)}{\sum I_0(hkl)}}{1 - \dfrac{\sum' I_0(HKL)}{\sum I_0(hkl)}} \times 100 \ \%$$

Here, $\sum I(hkl)$ represents a sum of X-ray diffraction intensities of all the crystal faces (hkl) measured on the bonding face, $\sum I_0(hkl)$ represents a sum of X-ray diffraction intensities measured on a sample of the same material which is not oriented, $\sum' I(HKL)$ represents a sum of X-ray diffraction intensities of a specific crystalline face (for example 006 face) measured on the bonding surface, and $\sum' I_0(HKL)$ represents a sum of X-ray diffraction intensities of a specific crystalline face (for example 006 face) measured on a sample of the same material which is not oriented.

Although various kinds of known methods can be utilized as a method of orientating the crystals, it is desired a method of utilizing magnetic field on the viewpoint of controlling the orientation. Specifically, after the slurry is cast into a mold according to the gel cast molding as described above, it is solidified in the magnetic field. At this time, the used metal mold is made of a material, which is not affected by the magnetic field, such as glass, aluminum alloy or cooper alloy. Further, the orientation cannot be performed in the case that the intensity of the applied magnetic field is too low, and a sintering aid is segregated and abnormal grains are generated after the sintering in the case it is too high. It may preferably be in a range of 5T to 12T.

(Surface treatment of handle substrate)

The blank substrate 12 is subjected to precise polishing to lower the microscopic center line surface roughness Ra of the surface of each crystal grain. Such polishing includes the following as an example.

That is, as a surface shaping treatment of the substrate, it is performed lapping using GC (green carbon). It is then subjected to lapping using diamond abrasives so that the surface is made a mirror face.

Further, after the microscopic average surface roughness Ra of the surface of each crystal grain is made smaller, additional finishing is further performed, so that the central line surface roughness Ra of the crystal grain is made 5nm or smaller and the height differences are generated between the crystal grains. Such finishing may preferably be a process including chemical etching and may most preferably be the following.

That is, time duration for performing the final CMP process using colloidal silica is made longer than that applied in conventional CMP condition so that the effect of the processing by the chemical etching can be made more considerable. It is thus possible to make the formation of the height differences, due to the differences of etching rate among the crystal grains, considerable.

(Embodiment of bonding)

Further, as a technique used for the bonding, it may be used direct bonding through surface activation and substrate bonding technique using an adhesive layer, for example, although it is not particularly limited.

As the direct bonding, it may be appropriately used low-temperature bonding technique through surface activation. After the surface activation is performed in vacuum of about $10^{-6}$ Pa using Ar gas, a single crystalline material, such as Si, can be bonded to a polycrystalline material through an adhesive layer such as $SiO_2$ at ambient temperature.

As an example of the adhesive layer, $SiO_2$, $Al_2O_3$ and SiN are used in addition to the adhesion with a resin.

EXAMPLES

It was produced a handle substrate 11 using translucent alumina ceramics, for conforming the effects of the present invention.

First, it was produced a blank substrate 12 made of translucent alumina ceramics.

Specifically, it was produced slurry by mixing the following ingredients.

(Powdery raw material)

| | |
|---|---|
| $\alpha$ -alumina powder havinga specific surface area of 3.5 to 4.5 $m^2$/g and an average primary particle size of 0.35 to 0.45 $\mu$ m | 100 weight parts |
| MgO (magnesia) | 0.025 weight parts |
| $ZrO_2$ (zirconia) | 0.040 weight parts |
| $Y_2O_3$ (yttria) | 0.0015 weight parts |

(Dispersing medium)

| | |
|---|---|
| Dimethyl glutarate | 27 weight parts |
| Ethylene glycol | 0.3 weight parts |

(Gelling agent)

| | |
|---|---|
| MDI resin | 4 weight parts |

(Dispersing agent)

| | |
|---|---|
| High molecular surfactant | 3 weight parts |

(Catalyst)

| | |
|---|---|
| N, N-dimethylaminohexanol | 0.1 weight parts |

The slurry of the mixture described above was cast into a mold made of an aluminum alloy at room temperature and then maintained at room temperature for 1 hour. It was then maintained at 40°C for 30 minutes for the solidification and then released from the mold. It was further maintained at room temperature and 90°C for 2 hours, respectively, to obtain a plate-like powder molded body.

The thus obtained powder molded body was calcined (preliminary sintering) in air at 1100°C, then sintered in atmosphere of hydrogen 3: nitrogen 1 at 1700 to 1800°C, and then annealed under the same condition to produce the blank substrate 12 composed of a polycrystalline material.

The thus produced blank substrate 12 was subjected to high-precision polishing. First, both faces were subjected to lapping using green carbon to adjust the shape, and the surface was then subjected to single-face lapping using diamond slurry having a particle size of 6 $\mu$ m. It was performed CMP polishing using colloidal silica, for obtaining the target surface roughness and the desired height differences along the grain boundaries. It was thus obtained the surface morphology as shown in Figs. 5 and 6.

As to the thus obtained handle substrate, it was measured a central line average surface roughness Ra of the surface of each crystal grain on the surface 15 in microscopic view to obtain a value lower than 1nm. Besides, the measurement is performed as follows.

In the case that the surface roughness of each crystal grain is microscopically observed, it is applied observation of Ra value in a visual field of 10 $\mu$ m by means of AFM (Atomic force Microscope).

As to the thus obtained handle substrate, it was measured the height difference between the crystal grains present on the surface to obtain a value of 30nm as PV value. Besides, the measurement is performed as follows.

In the case that the surface roughness is measured in macroscopic field including the height differences between the crystal grains, it is applied measurement of Rt value (measurement of PV value) in a wide visual field (visual field of 30 $\mu$ m or larger) by means of AFM measurement.

Further, the crystal orientation of alumina forming the handle substrate was 70 percent.

$SiO_2$ layer was formed on the surface of the thus obtained handle substrate as the adhesive layer to a silicon thin plate. Plasma CVD was applied for forming the film, and CMP polishing (Chemical mechanical polishing) was performed after the film formation so that the film thickness of the finally obtained $SiO_2$ layer was made 100nm. Thereafter, plasma activation method was performed so that the Si substrate and $SiO_2$ layer were bonded with each other to produce a composite substrate composed of Si-$SiO_2$-handle substrate. Further, the Si layer was thinned by polishing so that the thickness of the Si layer was made 500nm.

The thus obtained composite substrate was heat treated at 1000°C for 30 minutes, and it was thereby proved that the state of the bonding was not changed, cracks and peeling were not generated, and the anchor effect was sufficiently obtained due to the formed fine recesses.

(Examples 2 to 11)

Composite substrates were produced according to the same procedure as the Example 1, and the presence or absence of the peeling was evaluated. Besides, the intensity of the magnetic field applied during the molding and condition of the CMP polishing were adjusted so that the orientations and sizes of the height differences in the grain boundaries were controlled.

The results of incidence of peeling were shown in tables 1 and 2.

(Comparative Example 1)

For comparing the adhesive strength of a substrate without the height differences, it was produced, as a handle substrate, a composite substrate having an Si substrate and LT (lithium tantalite) directly bonded thereto as a functional layer. The surface of the LT does not include physical height differences and has Ra of 0.5nm and PV value of 2nm. The LT side surface of the handle substrate was adhered onto a donor substrate composed of Si by direct bonding through surface activation method, and its film thickness was made 20 $\mu$ m by polishing. The thus finished substrate was cut using a diamond blade so that it was partly observed peeling starting from the bonding interface.

Table 1

|  | Example 1 | Example 2 | Example 3 | Example 4 | Example 5 | Example 6 |
|---|---|---|---|---|---|---|
| Height differences (nm) | 30 | 3 | 5 | 8 | 30 | 50 |
| Orientation (%) | 70 | < 1 | < 1 | < 1 | < 1 | < 1 |
| Incidence of Peeling (%) | 0 | 17 | 14 | 10 | 9 | 12 |

Table 2

|  | Example 7 | Example 8 | Example 9 | Example 10 | Example 11 | Com. Ex. 1 |
|---|---|---|---|---|---|---|
| Height differences (nm) | 100 | 30 | 30 | 30 | 30 | 0 |
| Orientation (%) | < 1 | 30 | 50 | 90 | 95 | 0 |
| Incidence of Peeling (%) | 24 | 8 | 5 | 4 | 9 | 50 |

**Claims**

1. A composite substrate for a semiconductor comprising a handle substrate (11, 11A) and a donor substrate bonded with a bonding surface of said handle substrate directly or through a bonding layer, wherein

   said handle substrate comprises an insulating polycrystalline material of crystal grains (2,7),
   **characterized in that**
   a respective exposed face of each grain exposing to said bonding surface (15) of the handle substrate (11, 11A) has a central line average surface roughness Ra of 5nm or smaller;
   a height difference (h) between the exposed faces (2a, 7a) of the crystal grains exposing to said bonding surface (15) of the handle substrate (11, 11A) is 3nm or larger and 100 nm or smaller.

2. The composite substrate of claim 1, wherein said insulating polycrystalline material comprises an oriented ceramics.

3. The composite substrate of claim 2, wherein said oriented ceramics has an orientation of 30 percent or higher and 95 percent or lower.

4. The composite substrate of any one of claims 1 to 3, wherein said insulating polycrystalline material comprises a translucent alumina ceramics.

**Patentansprüche**

1. Kompositsubstrat für einen Halbleiter, das ein Handhabungssubstrat (11, 11A) und ein Donorsubstrat, das mit einer Bindungsoberfläche des Handhabungssubstrats direkt oder durch eine Verbindungsschicht verbunden ist, aufweist, wobei

   das Handhabungssubstrat ein isolierendes polykristallines Material aus Kristallkörnern (2, 7) aufweist,
   **dadurch gekennzeichnet, dass**
   eine jeweilige außenliegende Fläche von jedem Korn, das an der Bindungsoberfläche (15) des Handhabungssubstrats (11, 11A) außen liegt, eine zentrale Liniendurchschnittsoberflächenrauheit Ra von 5 nm oder kleiner hat;
   eine Höhendifferenz (h) zwischen den außenliegenden Flächen (2a, 7a) der Kristallkörner, die an der Bindungsoberfläche des Handhabungssubstrats (11, 11A) außen liegen, 3 nm oder größer und 100 nm oder kleiner ist.

2. Kompositsubstrat nach Anspruch 1, wobei das isolierende polykristalline Material eine orientierte Keramik aufweist.

3. Kompositsubstrat nach Anspruch 2, wobei die orientierte Keramik eine Orientierung von 30 Prozent oder mehr und 95 Prozent oder weniger aufweist.

4. Kompositsubstrat nach einem der Ansprüche 1 bis 3, wobei das isolierende polykristalline Material eine durchscheinende Aluminiumoxydkeramik aufweist.

**Revendications**

1. Substrat composite pour un semi-conducteur comprenant un substrat de manipulation (11, 11A) et un substrat donneur collé à une surface de collage dudit substrat de manipulation directement ou par l'intermédiaire d'une couche de collage, dans lequel

ledit substrat de manipulation comprend un matériau polycristallin isolant en grains cristallins (2, 7),
**caractérisé en ce que**
une face exposée respective de chaque grain s'exposant à ladite surface de collage (15) du substrat de manipulation (11, 11A) a une rugosité de surface moyenne sur la ligne centrale Ra de 5 nm ou moins ;
la différence de hauteur (h) entre les faces exposées (2a, 7a) des grains cristallins s'exposant à ladite surface de collage (15) du substrat de manipulation (11, 11A) est de 3 nm ou plus et de 100 nm ou moins.

2. Substrat composite selon la revendication 1, dans lequel ledit matériau polycristallin isolant comprend une céramique orientée.

3. Substrat composite selon la revendication 2, dans lequel ladite céramique orientée a une orientation de 30 % ou plus et de 95 % ou moins.

4. Substrat composite selon l'une quelconque des revendications 1 à 3, dans lequel ledit matériau polycristallin isolant comprend une céramique d'alumine translucide.

Fig. 1

(a)

(b)

# Fig. 2

(a)

12a

12

12b

(b)

5

1

(c)

15

11

11b

(d)

15  17  16  20A(21A)

11(11A)

11b

(e)

17  15  20B(21B)

11(11A)

11b

Fig. 3

(a) 20A

(b) 20B

## Fig. 4

(a)

(b)

14

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H08512432 A
- JP 2003224042 A
- JP 2010278341 A
- WO 2010128666 A1
- JP H05160240 A
- JP 2008288556 A
- EP 2100989 A1
- US 20120228612 A1